(19) 

Europäisches Patentamt
European Patent Office
Office européen des brevets

(11) **EP 4 407 660 A1**

(12) **EUROPEAN PATENT APPLICATION**
published in accordance with Art. 153(4) EPC

(43) Date of publication:
**31.07.2024 Bulletin 2024/31**

(21) Application number: **22872651.9**

(22) Date of filing: **30.08.2022**

(51) International Patent Classification (IPC):
**H01L 21/365** (2006.01)    **H01L 21/368** (2006.01)
**C30B 29/16** (2006.01)    **C23C 16/40** (2006.01)
**C23C 16/455** (2006.01)

(52) Cooperative Patent Classification (CPC):
**C23C 16/40; C23C 16/455; C23C 16/46;
C30B 29/16; H01L 21/02107**

(86) International application number:
**PCT/JP2022/032486**

(87) International publication number:
**WO 2023/047895 (30.03.2023 Gazette 2023/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.09.2021   JP 2021154679**

(71) Applicant: **Shin-Etsu Chemical Co., Ltd.**
**Chiyoda-ku,**
**Tokyo 1000005 (JP)**

(72) Inventors:
• **WATABE, Takenori**
  **Annaka-shi, Gunma 379-0195 (JP)**
• **HASHIGAMI, Hiroshi**
  **Annaka-shi, Gunma 379-0195 (JP)**
• **SAKATSUME, Takahiro**
  **Annaka-shi, Gunma 379-0195 (JP)**

(74) Representative: **Mooser, Sebastian Thomas**
**Wuesthoff & Wuesthoff**
**Patentanwälte und Rechtsanwalt PartG mbB**
**Schweigerstraße 2**
**81541 München (DE)**

(54) **FILM-FORMING METHOD, FILM-FORMING DEVICE, AND CRYSTALLINE OXIDE FILM**

(57)    The present invention is a film-forming method for forming a crystalline oxide film, which contains gallium oxide as a main component, on a substrate by a mist CVD method, including: a step of heating a substrate; a step of heating a nozzle that supplies mist containing a raw material solution; and a step of forming the crystalline oxide film by supplying the mist onto the heated substrate so that a discharging direction of the heated nozzle is perpendicular to a surface of the substrate, wherein, in the step of heating the nozzle, the nozzle is heated in a state where the substrate is not present in the discharging direction of the nozzle, and, in the step of forming the crystalline oxide film, the film is formed in a state where the substrate is present in the discharging direction of the nozzle. As a result, the present invention provides a crystalline oxide film containing gallium oxide as a main component, which is excellent in crystallinity and ensures desirable inplane film thickness distribution even with a large area and a small film thickness, a film-forming method for forming such a crystalline oxide film, and a film-forming apparatus for performing the film-forming method.

[FIG. 1]

**Description**

TECHNICAL FIELD

The present invention relates to a film-forming method, a film-forming apparatus, and a crystalline oxide film.

BACKGROUND ART

As next-generation switching devices that achieve high breakdown voltage, low losses, and high heat resistance, semiconductor devices made by using gallium oxide ($Ga_2O_3$) with a large band gap are attracting attention. These semiconductor devices containing gallium oxide are expected to be applied to semiconductor power devices such as inverters. In addition, owing to its wide band gap, gallium oxide is also expected to be widely applied as a light-receiving/emitting device such as an LED or a sensor. In particular, among gallium oxides, the band gap of $\alpha$-$Ga_2O_3$ or the like having a corundum structure can be controlled by solely using indium or aluminum, or mixed crystals thereof, and such InAlGaO-based semiconductors are therefore available as extremely attractive materials. The InAlGaO-based semiconductors herein refer to $In_xAl_yGa_zO_3$ ($0 \leq X \leq 2$, $0 \leq Y \leq 2$, $0 \leq Z \leq 2$, $X+Y+Z=1.5$ to $2.5$), and they can be considered as the same material line containing gallium oxide.

However, since the most stable phase of gallium oxide is $\beta$-gallia structure, it is difficult to form a crystal film having a corundum structure, which is a metastable phase, unless a special film-forming method is used. For example, crystal growth conditions are often limited to heteroepitaxial growth or the like, which is likely to increase the dislocation density. Further, in addition to crystal films having a corundum structure, there are still many issues to be addressed including improvement in film-forming rate and crystal quality, suppression of cracks and abnormal growth, twinning suppression, cracking of substrates due to warping, and the like. Under such circumstances, several studies are currently conducted on the film formation of crystalline semiconductors having a corundum structure.

Patent Document 1 discloses a method of producing an oxide crystal thin film by a mist CVD method using bromides or iodides of gallium or indium. Patent Documents 2 to 4 disclose a multilayer structure in which a semiconductor layer having a corundum crystal structure and an insulating film having a corundum crystal structure are laminated on a base substrate having a corundum crystal structure. Further, film formation by a mist CVD using ELO substrates or void formation has also been considered, as described in Patent Documents 5 to 7.

Patent Document 8 discloses formation of gallium oxide having a corundum structure by the Halide Vapor Phase Epitaxy (HVPE) method using at least a gallium raw material and an oxygen raw material. Furthermore, Patent Document 9 discloses ELO crystal growth using patterned substrates to obtain crystal films with a surface area of 9 $\mu m^2$ or more and a dislocation density of $5 \times 10^6$ cm$^{-2}$ or less.

CITATION LIST

PATENT LITERATURE

Patent Document 1: JP5397794B
Patent Document 2: JP5343224B
Patent Document 3: JP5397795B
Patent Document 4: JP2014-072533A
Patent Document 5: JP2016-100592A
Patent Document 6: JP2016-098166A
Patent Document 7: JP2016-100593A
Patent Document 8: JP2016-155714A
Patent Document 9: JP2019-034883A
Patent Document 10: WO2021/065940A1

SUMMARY OF INVENTION

TECHNICAL PROBLEM

However, gallium oxide has a problem in its heat dissipation, and to solve this problem, for example, it is necessary to reduce the film thickness of the gallium oxide to 30 um or less. This requires a complicated polishing step and increases the costs. In addition, in the first place, if the film is thinned by polishing, it is difficult to obtain a large-area gallium oxide film while maintaining the film thickness distribution. In addition, when applied to vertical devices, the series resistance was not fully satisfactory. Therefore, in order to allow gallium oxide to fully demonstrate the performance as a power semiconductor device, it is desirable to obtain a thin gallium oxide film having, for example, a thickness of 30 um or less, with a large area and desirable film thickness distribution, and such a crystal film has been in demand for a long time.

To address this problem, Patent Document 10 discloses a method of obtaining a gallium oxide film with desirable film thickness distribution using an ELO mask. However, this method requires a complicated process as it involves a delamination step and a polishing step, and such a complicated process results in a decrease in yield.

An object of the present invention is to provide a crystalline oxide film containing gallium oxide as a main component. The crystalline oxide film of the present invention is excellent in crystallinity and ensures desirable in-plane film thickness distribution even with a large area and a small film thickness, and also ensures excellent semiconductor characteristics when applied to a semiconductor device. The present invention also provides a film-forming method for forming such a crystalline oxide film and a production apparatus for performing the film-forming method.

SOLUTION TO PROBLEM

The present invention was made to achieve the above objects and provides a film-forming method for forming a crystalline oxide film, which contains gallium oxide as a main component, on a substrate by a mist CVD method, comprising: a step of heating a substrate; a step of heating a nozzle that supplies mist containing a raw material solution; and a step of forming the crystalline oxide film by supplying the mist onto the heated substrate so that a discharging direction of the heated nozzle is perpendicular to a surface of the substrate, wherein, in the step of heating the nozzle, the nozzle is heated in a state where the substrate is not present in the discharging direction of the nozzle, and in the step of forming the crystalline oxide film, the film is formed in a state where the substrate is present in the discharging direction of the nozzle.

Such a film-forming method makes it possible to obtain a crystalline oxide film, which contains gallium oxide as a main component, excellent in crystallinity and ensuring desirable in-plane film thickness distribution even with a small film thickness, and also ensuring excellent semiconductor characteristics when applied to a semiconductor device.

The film-forming method may be arranged such that the substrate is heated by using a substrate heating means having a substrate mounting portion and a substrate non-mounting portion by placing the substrate on the substrate mounting portion, and, in the step of heating the nozzle, the nozzle is heated by the substrate heating means while positioning the substrate non-mounting portion in the discharging direction of the nozzle.

This allows for the use of a simplified film-forming apparatus, which is cost effective.

The film-forming method may be arranged such that the nozzle is heated by a nozzle heating means provided in the nozzle.

This allows efficient heating of the nozzle.

The present invention also provides a film-forming method for forming a crystalline oxide film, which contains gallium oxide as a main component, on a substrate by a mist CVD method, comprising: a step of heating a substrate; a step of heating a film-forming member; and a step of forming the crystalline oxide film by supplying mist in a state where the heated film-forming member is present on the substrate in a normal direction with respect to a surface of the substrate, wherein, in the step of heating the film-forming member, the film-forming member is heated in a state where the film-forming member is not present on the substrate in the normal direction with respect to the surface of the substrate.

Such a film-forming method makes it possible to obtain a crystalline oxide film, which contains gallium oxide as a main component, excellent in crystallinity and ensuring desirable in-plane film thickness distribution even with a small film thickness, and also ensuring excellent semiconductor characteristics when applied to a semiconductor device.

The film-forming method may be arranged such that, in the step of heating the substrate, a substrate heating means having a substrate mounting portion and a substrate non-mounting portion is used, and the substrate is heated by being placed on the substrate mounting portion, and, in the step of heating the film-forming member, the film-forming member is positioned on the substrate non-mounting portion in a normal direction with respect to a surface of the substrate non-mounting portion, and the film-forming member is heated by the substrate heating means.

This allows for the use of a simplified film-forming apparatus, which is cost effective.

The film-forming method may be arranged such that, in the step of heating the film-forming member, the film-forming member is heated by a film-forming member heating means provided in the film-forming member.

This allows efficient heating of the film-forming member.

The film-forming method may be arranged such that the film-forming member is a nozzle for supplying the mist onto the substrate, and, in the step of heating the film-forming member, the nozzle is heated in a state where a discharging port of the nozzle is not present on the substrate in the normal direction with respect to the surface of the substrate.

This allows more effective production of a crystalline oxide film, which contains gallium oxide as a main component and ensures desirable film thickness distribution.

The film-forming method may be arranged such that a substrate having a film-forming surface with an area of 100 mm² or more, a substrate having a diameter of 2 inches (50 mm) or more, or a substrate having a diameter of 4 inches (100 mm) to 8 inches (200 mm) is used.

The film-forming method of the present invention allows for the production of a crystalline oxide film with a desirable film thickness distribution even on such large-area substrates.

The present invention was made to achieve the above objects and also provides a film-forming apparatus that performs a mist CVD method, comprising: a substrate heating means having a substrate mounting portion on which a substrate is mounted; a nozzle that supplies mist containing a raw material solution, a discharge direction of which is perpendicular to a surface of the substrate; and a position adjusting means for the nozzle and/or the substrate heating means, the position adjusting means being capable of adjusting a position of the substrate mounting portion to a position in the discharging direction of the nozzle and to a position other than the discharging direction of the nozzle.

Such a film-forming apparatus is capable of performing the afore-mentioned film-forming method, and makes it possible to obtain a crystalline oxide film, which contains gallium oxide as a main component and is excellent in crystallinity and ensures desirable in-plane film thickness distribution even with a small film thickness.

The film-forming apparatus may be arranged such that the substrate heating means further comprises a substrate non-mounting portion, and the position adjusting means for the nozzle and/or the substrate heating means is capable of adjusting a position of the substrate non-mounting portion to a position of the discharging direction of the nozzle.

This simplifies the structure of the apparatus and also decreases the size of the apparatus itself as well as the footprint, which is cost effective.

The film-forming apparatus may be arranged such that the nozzle comprises a nozzle heating means for heating the nozzle.

This allows efficient and more flexible heating of the nozzle.

The present invention also provides a film-forming apparatus that performs a mist CVD method, comprising: a substrate heating means having a substrate mounting portion on which a substrate is mounted; a film-forming member; and a position adjusting means capable of adjusting a position of the film-forming member to a position other than a position on the substrate mounting portion in a normal direction with respect to a surface of the substrate mounting portion.

Such a film-forming apparatus is capable of performing the afore-mentioned film-forming method, and makes it possible to obtain a crystalline oxide film, which contains gallium oxide as a main component and is excellent in crystallinity and ensures desirable in-plane film thickness distribution even with a small film thickness.

The film-forming apparatus may be arranged such that the substrate heating means further comprises a substrate non-mounting portion, and the position adjusting means for the film-forming member and/or the substrate heating means is capable of adjusting the position of the film-forming member to a position on the substrate non-mounting portion in a normal direction with respect to a surface of the substrate non-mounting portion.

This simplifies the structure of the apparatus and also decreases the size of the apparatus itself as well as the footprint, which is cost effective.

The film-forming apparatus may be arranged such that the film-forming member comprises a film-forming member heating means for heating the film-forming member.

This allows efficient and more flexible heating of the film-forming member.

The film-forming apparatus may be arranged such that the film-forming member is a nozzle for supplying mist onto the substrate or a top plate for rectifying the supplied mist on the substrate.

This film-forming apparatus allows more effective production of a crystalline oxide film, which contains gallium oxide as a main component and ensures desirable in-plane film thickness distribution.

The present invention was made to achieve the above objects and provides a crystalline oxide film containing gallium oxide as a main component, the crystalline oxide film having a V-value of 0.045 or less for each film thickness at 25 points in its plane, the V-value being obtained by the following formula (1),

[Math. 1]

$$V = \frac{\sum_{i=1}^{25} x_i{}^2}{\left(\sum_{i=1}^{25} x_i\right)^2} \qquad (1)$$

wherein $x_i$ is the i-th (i=1 to 25) measurement value.

Such a crystalline oxide film ensures desirable film thickness distribution, and when the crystalline oxide film is used as a power semiconductor device, the performance thereof can be fully demonstrated, and the variation in performance can be suppressed.

The crystalline oxide film may be arranged such that the V-value is 0.041 or less.

Such a crystalline oxide film ensures more desirable film thickness distribution and more effectively suppresses variation in performance when the crystalline oxide film is used as a power semiconductor device.

It is also possible to provide a layered structure containing a substrate having a diameter of 4 inches (100 mm) to 8 inches (200 mm) and the crystalline oxide film provided on the substrate.

Such a layered structure containing a large-area crystalline oxide film with a desirable film thickness distribution can fully demonstrate the performance of the crystalline oxide film when applied as a power semiconductor device, and the variation in performance thereof can be suppressed.

It is also possible to provide a product lot of semiconductor devices, comprising two or more of only semiconductor devices produced from the layered structure described above, and having a breakdown voltage yield of 75% or more.

Such a product lot have a high yield.

The present invention also provides a film-forming method for forming a crystalline oxide film, which contains gallium oxide as a main component, on a substrate by a mist CVD method, comprising: a step of heating a substrate; a step of heating a nozzle that supplies mist containing a raw material solution to a predetermined temperature; and a step of leading the mist to the substrate to form a crystalline oxide film, and exhausting the mist after film formation, wherein, in the step of heating the nozzle to a predetermined temperature, discharged matters discharged from the nozzle are exhausted without passing through the substrate.

Such a film-forming method makes it possible to obtain a crystalline oxide film, which contains gallium oxide as a main component, excellent in crystallinity and ensuring desirable in-plane film thickness distribution even with a small film thickness, and also ensuring excellent semiconductor characteristics when applied to a semiconductor devices.

The present invention also provides a film-forming apparatus that performs a mist CVD method, comprising: a substrate heating means having a substrate mounting portion on which a substrate is mounted; a nozzle for supplying mist onto the substrate; and an exhausting means for exhausting the mist after film formation, wherein the exhausting means has a mechanism that exhausts discharged matters discharged from the nozzle without passing through the substrate mounting portion.

Such a film-forming apparatus is capable of performing the afore-mentioned film-forming method, and makes it possible to obtain a crystalline oxide film, which contains gallium oxide as a main component and is excellent in crystallinity and ensures desirable in-plane film thickness distribution even with a small film thickness.

ADVANTAGEOUS EFFECTS OF INVENTION

As described above, the film-forming method of the present invention makes it possible to provide a crystalline oxide film, which contains gallium oxide as a main component, excellent in crystallinity and ensuring desirable in-plane film thickness distribution even with a small film thickness, and also ensuring excellent semiconductor characteristics when applied to a semiconductor devices. The film-forming apparatus of the present invention is capable of performing the afore-mentioned film-forming method, and makes it possible to obtain a crystalline oxide film, which contains gallium oxide as a main component and is excellent in crystallinity and ensures desirable in-plane film thickness distribution even with a small film thickness. The crystalline oxide film of the present invention ensures desirable film thickness distribution, and when the crystalline oxide film is used as a power semiconductor device, the performance thereof can be fully demonstrated, and the variation in performance can be suppressed.

BRIEF DESCRIPTION OF DRAWINGS

FIG. 1 is a first example of heating a nozzle.
FIG. 2 is a second example of heating a nozzle.
FIG. 3 is a third example of heating a nozzle.
FIG. 4 is a fourth example of heating a nozzle.
FIG. 5 is a schematic diagram of a film-forming apparatus that performs film formation by mist CVD method.
FIG. 6 is a diagram for explaining an example of a mist-forming unit in a film-forming apparatus.
FIG. 7 is a schematic diagram of an example of a semiconductor device according to the present invention.

DESCRIPTION OF EMBODIMENTS

The present invention is described below in detail; however, the present invention is not limited to the examples described below.

As described above, provision of a crystalline oxide film containing gallium oxide as a main component, which is excellent in crystallinity, ensures desirable in-plane film thickness distribution even with a large area and a small film thickness, and also ensures excellent semiconductor characteristics when applied to a semiconductor device, a film-forming method for forming such a crystalline oxide film, and a production apparatus for performing the film-forming method have been in demand.

The present inventors have conducted extensive study on the above-mentioned problems and found that a crystalline oxide film containing gallium oxide as a main component, which is excellent in crystallinity, ensures desirable in-plane film thickness distribution even with a small film thickness, and also ensures excellent semiconductor characteristics when applied to a semiconductor device can be obtained by a film-forming method for forming a crystalline oxide film, which contains gallium oxide as a main component, on a substrate by a mist CVD method, comprising: a step of heating a substrate; a step of heating a nozzle that supplies mist containing a raw material solution; and a step of forming the crystalline oxide film by supplying the mist onto the heated substrate so that a discharging direction of the heated nozzle is perpendicular to a surface of the substrate, wherein in the step of heating the nozzle, the nozzle is heated in a state where the substrate is not present in the discharging direction of the nozzle, and in the step of forming the crystalline oxide film, the film is formed in a state where the substrate is present in the discharging direction of the nozzle. With this finding, the present inventors completed the present invention.

The present inventors also found that such a crystalline oxide film containing gallium oxide as a main component, which is excellent in crystallinity, ensures desirable in-plane film thickness distribution even with a small film thickness, and also ensures excellent semiconductor characteristics when applied to a semiconductor device can be obtained by a film-forming method for forming a crystalline oxide film, which contains gallium oxide as a main component, on a substrate by a mist CVD method, comprising: a step of heating a substrate; a step of heating a film-forming member; and a step of forming the crystalline oxide film by supplying mist in a state where the heated film-forming member is present on the substrate in a normal direction with respect to a surface of the substrate, wherein, in the step of heating the film-forming member, the film-forming member is heated in a state where the film-forming member is not present on the substrate in the normal direction with respect to the surface of the substrate. Also with this finding, the present inventors completed the present invention.

The present inventors also found that a crystalline oxide film containing gallium oxide as a main component, which is excellent in crystallinity, ensures desirable in-plane film thickness distribution even with a thin film thickness can be obtained by a film-forming apparatus that performs a mist CVD method, comprising: a substrate heating means having a substrate mounting portion on which a substrate is mounted; a nozzle that supplies mist containing a raw material solution, a discharge direction of which is perpendicular to a surface of the substrate; and a position adjusting means for the nozzle and/or the substrate heating means, the position adjusting means being capable of adjusting a position of the substrate mounting portion to a position in the discharging direction of the nozzle and to a position other than the discharging direction of the nozzle. Also with this finding, the present inventors completed the present invention.

The present inventors also found that the aforementioned film-forming method can be performed by a film-forming apparatus that performs a mist CVD method, comprising: a substrate heating means having a substrate mounting portion on which a substrate is mounted; a film-forming member; and a position adjusting means capable of adjusting a position of the film-forming member to a position other than a position on the substrate mounting portion in a normal direction with respect to a surface of the substrate mounting portion; and that this film-forming apparatus is capable of producing a crystalline oxide film containing gallium oxide as a main component, which is excellent in crystallinity, ensures desirable in-plane film thickness distribution even with a small film thickness. Also with this finding, the present inventors completed the present invention.

The present inventors also found that a crystalline oxide film that ensures desirable film thickness distribution and also fully demonstrates performance of the crystalline oxide film when applied to a power semiconductor device with less variation in performance can be obtained by a crystalline oxide film containing gallium oxide as a main component, the crystalline oxide film having a V-value of 0.045 or less for each film thickness at 25 points in its plane, the V-value being obtained by the following formula (1). Also with this finding, the present inventors completed the present invention.

[Math. 2]

$$V = \frac{\sum_{i=1}^{25} x_i{}^2}{\left(\sum_{i=1}^{25} x_i\right)^2} \tag{1}$$

wherein $x_i$ is the i-th (i=1 to 25) measurement value.

The present inventors also found that such a crystalline oxide film containing gallium oxide as a main component, which is excellent in crystallinity, ensures desirable in-plane film thickness distribution even with a small film thickness, and also ensures excellent semiconductor characteristics when applied to a semiconductor device can be obtained by a film-forming method for forming a crystalline oxide film, which contains gallium oxide as a main component, on a substrate by a mist CVD method, comprising: a step of heating a substrate; a step of heating a nozzle that supplies mist containing a raw material solution to a predetermined temperature; and a step of leading the mist to the substrate to form a crystalline oxide film, and exhausting the mist after film formation, wherein, in the step of heating the nozzle to a predetermined temperature, discharged matters discharged from the nozzle are exhausted without passing through the substrate. Also with this finding, the present inventors completed the present invention.

The present inventors also found that the aforementioned film-forming method can be performed by a film-forming apparatus that performs a mist CVD method, comprising: a substrate heating means having a substrate mounting portion on which a substrate is mounted; a nozzle for supplying mist onto the substrate; and an exhausting means for exhausting the mist after film formation, wherein the exhausting means has a mechanism that exhausts discharged matters discharged from the nozzle without passing through the substrate mounting portion; and that this film-forming apparatus is capable of producing a crystalline oxide film containing gallium oxide as a main component, which is excellent in crystallinity, ensures desirable in-plane film thickness distribution even with a small film thickness. Also with this finding, the present inventors completed the present invention.

Descriptions are given below with reference to drawings.

(Crystalline Oxide Film)

First, a crystalline oxide film according to the present invention is described below. The crystalline oxide film according to the present invention is an crystalline oxide film that contains gallium oxide as a main component and that has a V-value of 0.045 or less for each film thickness at 25 points in its plane, the V-value being obtained by the following formula (1).

[Math. 3]

$$V = \frac{\sum_{i=1}^{25} x_i{}^2}{\left(\sum_{i=1}^{25} x_i\right)^2} \tag{1}$$

wherein $x_i$ is the i-th (i=1 to 25) measurement value.

Such a crystalline oxide film according to the present invention ensures desirable film thickness distribution, and when the crystalline oxide film is used as a power semiconductor device, the performance thereof can be fully demonstrated, and the variation in performance can be suppressed. In the following description, "crystalline oxide film containing gallium oxide as a main component" may also be simply referred to as "a crystalline oxide film".

Although crystalline oxide films are generally composed of metal and oxygen, it is sufficient that the crystalline oxide film according to the present invention contains gallium as the metal as the main component. In the present invention, "containing gallium oxide as a main component" means that 50 to 100% of the metal component is gallium. As metal components other than gallium, for example, one or more metals selected from iron, indium, aluminum, vanadium, titanium, chromium, rhodium, iridium, nickel, and cobalt may be contained.

The crystalline oxide film may contain dopant elements. Examples of dopant elements include, but not particularly limited to, n-type dopants such as tin, germanium, silicon, titanium, zirconium, vanadium, or niobium; p-type dopants such as copper, silver, tin, iridium, rhodium, or magnesium; and the like. The concentration of the dopant may be, for example, about $1 \times 10^{16}/cm^3$ to $1 \times 10^{22}/cm^3$, and may be a low concentration of about $1 \times 10^{17}/cm^3$ or less or a high concentration of about $1 \times 10^{20}/cm^3$ or more.

The crystal structure of the crystalline oxide film is not limited, and may be a β-gallia structure, a corundum structure, or an orthorhombic crystal. The crystal structure may be a mixture of multiple crystal structures or polycrystalline; however, a monocrystalline or a uniaxially oriented film is preferable. Whether or not the film is monocrystalline or uniaxially oriented can be confirmed by a X-ray diffraction apparatus, an electron diffraction apparatus, or the like. When the film is irradiated with X-rays or electron beams, a diffraction image corresponding to the crystal structure can be obtained. If the film is uniaxially oriented, only specific peaks appear. This enables determination of a uniaxially oriented film.

Although the film thickness of the crystalline oxide film is not particularly limited, the film thickness is preferably 0.1 um or more. The upper limit of the film thickness is not particularly limited. For example, the film thickness may be 100 um or less, preferably 50 um or less, more preferably 30 um or less. The film thickness may be measured by any of the following methods: a stylus profilometer, a reflective spectroscopy film thickness meter, an ellipsometer, or observation of the cross section with SEM or TEM. In the crystalline oxide film according to the present invention, the V-value is 0.045 or less for each film thickness measured at 25 points in the plane of the crystalline oxide film. Here, the V-value is a dimensionless quantity defined by the following formula (1).

[Math. 4]

$$V = \frac{\sum_{i=1}^{25} x_i^2}{\left(\sum_{i=1}^{25} x_i\right)^2} \qquad (1)$$

wherein $x_i$ is the i-th (i=1 to 25) measurement value.

A smaller V-value indicates a smaller variation in film thickness. Therefore, the V-value is preferably 0.041 or less. A crystalline oxide film with a V-value of 0.041 or less is preferred because it ensures more desirable film thickness distribution and more effectively suppresses variation in performance when the crystalline oxide film is used as a power semiconductor device. Such a crystalline oxide film can be obtained by the mist CVD method using a mist CVD apparatus (film-forming apparatus) described later. The lower limit of the V-value is 0 or more.

(Layered Structure)

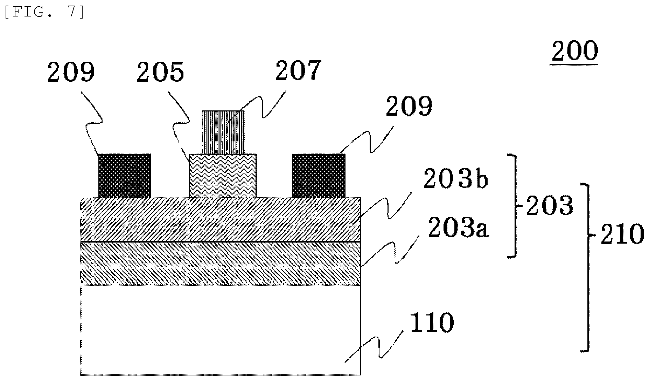

The layered structure 210 according to the present invention may be a structure in which at least a crystalline oxide film 203 is provided on a substrate 110, as shown in FIG. 7. The crystalline oxide film 203 may be a single layer or multiple layers, as shown in FIG. 7. The substrate in this structure can have a diameter of 4 inches (100 mm) to 8 inches (200 mm). With such a layered structure, excellent film thickness distribution over a large area can be obtained, and excellent semiconductor characteristics can be obtained when applied to semiconductor devices. That is, when a semiconductor device, such as a power semiconductor device, is manufactured from such a layered structure, the product lot containing two or more of the semiconductor devices can achieve a breakdown voltage yield of 75% or more.

Another layer may be interposed between the substrate 110 and the crystalline oxide film 203. Another layer is a layer having a composition different from those of the substrate and the crystalline oxide film at the top surface. The another substrate may also be referred to as a buffer layer. The buffer layer may be an oxide semiconductor film, an insulating film, a metal film, or the like, and materials such as $Al_2O_3$, $Ga_2O_3$, $Cr_2O_3$, $Fe_2O_3$, $In_2O_3$, $Rh_2O_3$, $V_2O_3$, $Ti_2O_3$, $Ir_2O_3$, and the like may be suitably used. The thickness of the buffer layer is preferably 0.1 um to 2 $\mu$m.

(Substrate)

The substrate used in the layered structure containing a crystalline oxide according to the present invention and in the film-forming method according to the present invention is not particularly limited as long as it can serve as a support for the crystalline oxide film described above. The material of the substrate is not particularly limited, and a known substrate can be used, and it may be an organic compound or an inorganic compound. Examples thereof include polysulfone, polyether sulfone, polyphenylene sulfide, polyetheretherketone, polyimide, polyetherimide, fluororesin, metals such as iron, aluminum, stainless steel, gold or the like, quartz, glass, calcium carbonate, gallium oxide, ZnO, and the like. In addition to these, examples also include substrates of monocrystal such as silicon, sapphire, lithium tantalate, lithium niobate, SiC, GaN, iron oxide, chromium oxide, and the like. These monocrystalline substrates are desirable in the layered structure according to the present invention. With these substrates, it is possible to obtain a crystalline oxide film of more desirable quality. In particular, sapphire substrates, lithium tantalate substrates, and lithium niobate substrates are relatively inexpensive and are therefore industrially advantageous.

The thickness of the substrate is preferably 100 to 5000 um. The substrates with this range of thickness ensure easy handling and suppress thermal resistance during the film formation, thus more easily obtaining a film having a desirable quality.

There is no particular restriction on the size of the substrate. A substrate having an area of 100 mm$^2$ or more or a diameter of 2 inches (50 mm) or more is preferred because it produces a large-area film with desirable crystallinity. The upper limit of the area of the substrate is not particularly limited; however, the upper limit may be 100,000 mm$^2$ or less. Furthermore, by setting the diameter of the substrate between 4 inches (100 mm) and 8 inches (200 mm), the resulting layered structure can be more easily processed using existing processing apparatuses, which is industrially advantageous during the manufacture of semiconductor devices.

(Example of Structure of Semiconductor Device)

FIG. 7 shows a preferred example of a semiconductor device 200 using the layered structure 210 according to the present invention. In the example of FIG. 7, the crystalline oxide film 203 is formed on the substrate 110. The crystalline oxide film 203 is formed by laminating an insulating thin film 203a and a conductive thin film 203b in this order from the side of the substrate 110. A gate insulating film 205 is formed on the conductive thin film 203b. A gate electrode 207 is formed on the gate insulating film 205. Further, on the conductive thin film 203b, source/drain electrodes 209 are formed while sandwiching the gate electrode 207. This structure enables control of the depletion layer formed in the conductive thin film 203b by the gate voltage applied to the gate electrode 207, thereby enabling a transistor operation (FET device).

Examples of the semiconductor devices formed by using the layered structure according to the present invention include transistors such as MIS, HEMT, or IGBT, TFT, Schottkey Barrier Diodes (SBD) formed by using a semiconductor-metal junction, PN or PIN diodes formed by using a combination with other P-type layers, light-receiving/emitting devices, and the like. The layered structure according to the present invention is useful to improve the characteristics of these devices.

The crystalline oxide film and the layered structure according to the present invention described above can be produced by a mist CVD method. The following describes a film-forming apparatus and a film-forming method suitable for producing the crystalline oxide film and the layered structure according to the present invention. Here, the "mist" in the present invention refers to a general term for fine particles of a liquid dispersed in a gas, and includes those called mist, droplets, or the like. Descriptions are given below with reference to drawings.

Film-Forming Apparatus

(First Film-Forming Apparatus)

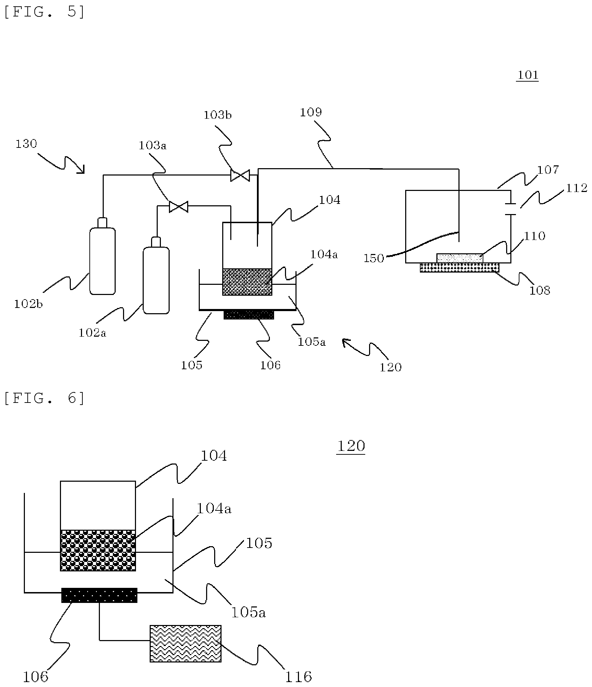

First, a first example of the film-forming apparatus according to the present invention is described below. FIG. 5 is a schematic diagram of a film-forming apparatus 101 that performs film formation by a mist CVD method. The film-forming apparatus 101 includes, at least, a mist-forming unit 120 that generates mist by atomizing a raw material solution 104a into a mist; a carrier gas supply unit 130 that supplies carrier gas for transporting the mist; a supply tube 109 that connects the mist-forming unit 120 and a film-forming chamber 107 and transports the mist by the carrier gas; the film-forming chamber 107 in which heat treatment of the mist is performed to form a film on the substrate 110; and a nozzle 150 that sprays the mist supplied from the supply tube 109 together with the carrier gas onto the substrate.

(Mist-Forming Unit)

The mist-forming unit 120 generates mist by atomizing the raw material solution 104a into a mist. The mist-forming means is not particularly limited as long as it is capable of atomizing the raw material solution 104a into a mist, and may be a known mist-forming means; however, a mist-forming means by way of ultrasonic vibration is preferable, because this mist-forming means is capable of stable atomization.

FIG. 6 shows an example of such a mist-forming unit 120. The mist-forming unit 120 may include a mist generation source 104 that contains a raw material solution 104a, a container 105 that contains a medium, such as water 105a, capable of transmitting ultrasonic vibrations, and an ultrasonic vibrator 106 attached to the bottom of the container 105. In detail, the mist generation source 104, which is formed of a container containing the raw material solution 104a, may be stored in the container 105 containing the water 105a using a support (not shown). The ultrasonic vibrator 106 may be provided at the bottom of the container 105, and the ultrasonic vibrator 106 and an oscillator 116 may be connected to each other. It may be configured such that, when the oscillator 116 is operated, the ultrasonic vibrator 106 vibrates, and the ultrasonic waves propagate into the mist generation source 104 via the water 105a, thereby atomizing the raw material solution 104a into a mist.

(Raw Material Solution)

The material contained in the raw material solution 104a is not particularly limited as long as it can be made into a mist, and may be an inorganic material or an organic material. Metals or metal compounds are preferably used as the material, and, for example, those containing one or more metals selected from gallium, iron, indium, aluminum, vanadium, titanium, chromium, rhodium, nickel and cobalt can be used. As such a raw material solution, those in which a metal is dissolved or dispersed in an organic solvent or water in the form of a complex or a salt can be preferably used. Examples of the salt form include halide salts such as chloride metal salt, bromide metal salt, iodide metal salt, and the like. Further, a solution in which the above metal is dissolved in hydrogen halide, such as, hydrobromic acid, hydrochloric acid, or hydroiodic acid, or the like, can also be used as a salt solution. Examples of the complex form include an acetylacetonate complex, a carbonyl complex, an ammine complex, a hydride complex, and the like. An acetylacetonate complex can also be formed by mixing acetylacetone with a solution of any of the aforementioned salts. The metal concentration in the raw material solution 104a is not particularly limited and may be 0.005 to 1 mol/L, for example.

An additive such as a hydrogen halide acid, an oxidizing agent, or the like may be mixed with the raw material solution. Examples of the hydrogen halide acid include hydrobromic acid, hydrochloric acid, hydroiodic acid, and the like. Among them, hydrobromic acid and hydroiodic acid are preferable. Examples of the oxidizing agent include peroxides such as hydrogen peroxide ($H_2O_2$), sodium peroxide ($Na_2O_2$), barium peroxide ($BaO_2$), benzoyl peroxide ($C_6H_5CO)_2O_2$, and like, and organic peroxides such as hypochlorous acid (HClO), perchloric acid, nitric acid, ozone water, peracetic acid, nitrobenzene, and like.

The raw material solution may contain a dopant. The dopant is not particularly limited. Example of the dopant include n-type dopants such as tin, germanium, silicon, titanium, zirconium, vanadium or niobium, p-type dopants such as copper, silver, iridium, rhodium or magnesium, and the like.

(Carrier Gas Supply Unit)

As shown in FIG. 5, the carrier gas supply unit 130 has a carrier gas source 102a that supplies a carrier gas. In this unit, a flow rate control valve 103a for adjusting the flow rate of the carrier gas delivered from the carrier gas source 102a may be provided. The unit may also be provided with a dilution carrier gas source 102b that supplies a dilution carrier gas, and a flow rate control valve 103b for adjusting the flow rate of the dilution carrier gas delivered from the dilution carrier gas source 102b as needed.

The type of carrier gas is not particularly limited and may be appropriately selected depending on the film to be formed. Examples of the carrier gas include oxygen, ozone, an inert gas such as nitrogen or argon, a reducing gas such as hydrogen gas or forming gas, and the like. Further, one type or two or more types of carrier gas may be used. For example, a diluted gas (for example, diluted 10-fold) obtained by diluting the same gas as the first carrier gas with another gas may further be used as the second carrier gas, or air may be used.

(Supply Tube)

The film-forming apparatus 101 has a supply tube 109 that connects the mist-forming unit 120 to the film-forming chamber 107. In this case, the mist is transported by a carrier gas from the mist generation source 104 in the mist-forming unit 120 into the film-forming chamber 107 via the supply tube 109. The supply tube 109 may be made of, for example, a quartz tube, a glass tube, a resin tube, or the like.

(Film-Forming Chamber)

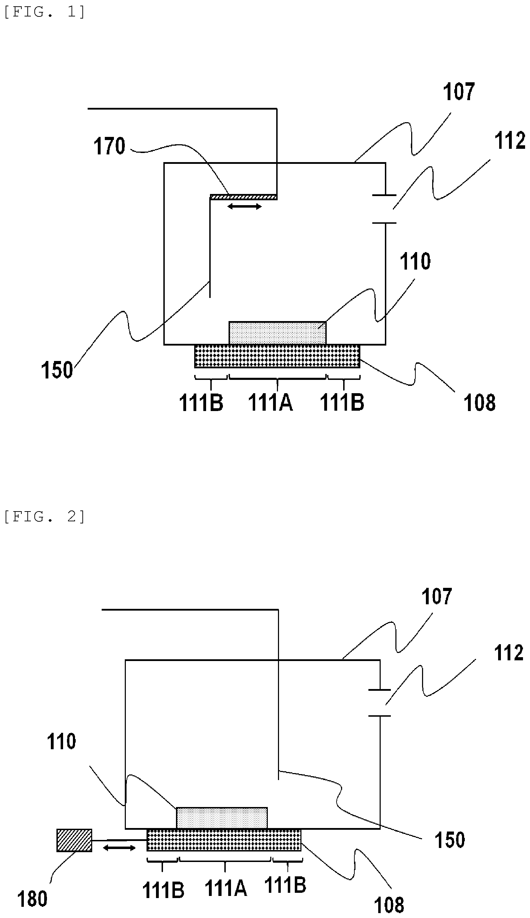

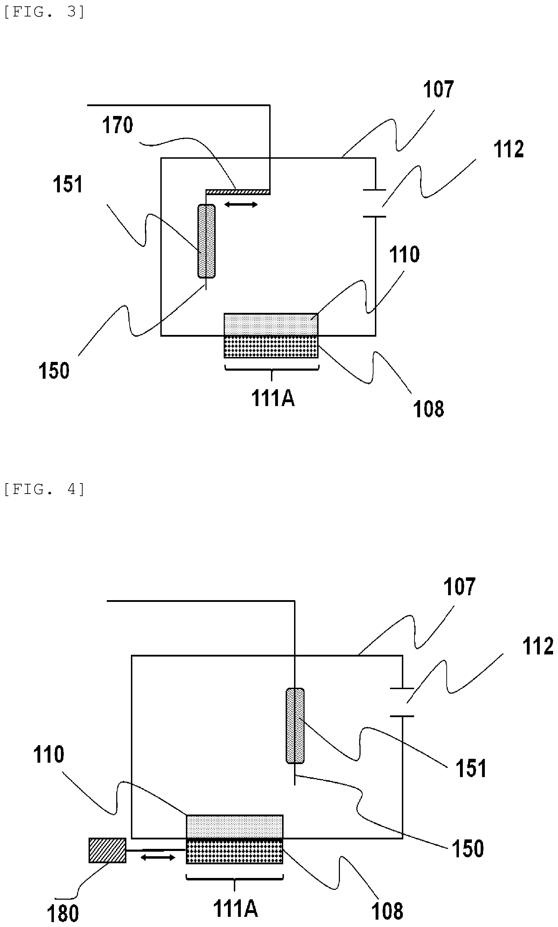

The substrate 110 is installed in the film-forming chamber 107. The film-forming chamber is equipped with a substrate heating means 108, such as a heater, for heating the substrate 110 mounted on a substrate mounting portion. The region in the substrate heating means 108 where the substrate is placed is hereinafter referred to as a "substrate mounting portion. Further, the "substrate non-mounting portion", which is described later, is a region in the substrate heating means where the substrate is not placed. For example, if the substrate mounting surface of the substrate heating means is larger than the substrate, the substrate heating means has a "substrate mounting portion" and a "substrate non-mounting portion" (see FIGS. 1 and 2). In some cases, the substrate heating means does not have a "substrate non-mounting portion," as in the case where the substrate mounting surface of the substrate heating means has the same size (or smaller) as that of the substrate (see FIGS. 3 and 4).

The substrate heating means 108 may be provided outside the film-forming chamber 107 as shown in FIG. 5 or inside the film-forming chamber 107. The film-forming chamber 107 has a nozzle 150 for spraying mist containing a raw material solution supplied from the supply tube 109 toward the substrate 110, together with a carrier gas. The discharging direction of the nozzle 150 during the film formation is perpendicular to the surface of the substrate 110.

The film-forming apparatus according to the present invention includes a position adjusting means for the nozzle and/or the substrate heating means, which is capable of adjusting the position of the substrate mounting portion to a position in the discharging direction of the nozzle 150 and to a position other than the discharging direction. As described above, if the position of the substrate mounting portion is adjustable with respect to the position of the discharging direction of the nozzle 150, the adverse effect on the substrate when the nozzle is heated, as in the film-forming method described below, can be suppressed.

FIGS. 1 to 4 show examples of heating a nozzle. The examples shown in FIGS. 1 and 3 are equipped with a position adjusting means 170 for the nozzle, thereby allowing the nozzle to move onto the substrate 110 (substrate mounting portion 111A) after the nozzle is heated, so that the substrate is present in the discharging direction of the nozzle. The position adjusting means 170 for the nozzle is not limited to a mechanism that moves the nozzle in parallel with the substrate as illustrated in FIGS. 1 and 3, but may also be a mechanism that tilts the angle of the nozzle.

The examples shown in FIGS. 2 and 4 are equipped with a position adjusting means 180 for the substrate heating means 108, which allows the substrate 110 (substrate mounting portion 111A) to move under the nozzle (discharging direction) after the nozzle is heated, so that the substrate is present in the discharging direction of the nozzle.

Further, in the examples shown in FIGS. 1 and 2, the substrate heating means 108 has a substrate mounting portion 111A and a substrate non-mounting portion 111B. In this case, the position adjusting means 170 for the nozzle and/or the position adjusting means 180 for the substrate heating means are preferably capable of adjusting the position of the substrate non-mounting portion 111B to a position in the discharging direction of the nozzle. Such an apparatus has an advantage in terms of cost because the structure of the apparatus is simplified and also the size of the apparatus itself as well as the footprint can be reduced; moreover, the nozzle can be efficiently heated by the substrate heating means.

Further, in the examples shown in FIGS. 3 and 4, a nozzle heating means 151 for heating the nozzle is provided in the nozzle 150. This allows the film-forming apparatus to be capable of performing heating and temperature control of the nozzle independently from the substrate, thereby increasing the degree of flexibility and more efficiently performing heating and temperature control of the nozzle.

In the film-forming apparatus shown in FIGS. 1 and 2, the nozzle heating means 151 may be provided in the nozzle 150. Further, in the film-forming apparatus shown in FIGS. 3 and 4, the substrate heating means 108 may have a substrate mounting portion 111A and a substrate non-mounting portion 111B. In this case, the nozzle can be heated more efficiently.

Further, the film-forming chamber 107 may be provided with an exhaust gas exhaust port 112 at a position that does not affect the supply of mist to the substrate 110. Further, for example, the substrate 110 may be installed facing down by being placed on the upper surface of the film-forming chamber 107, or the substrate 110 may be installed facing up by being placed on the bottom surface of the film-forming chamber 107. The angle of the surface of the substrate heating means on which the substrate 110 is installed with respect to the horizontal plane is also not particularly limited. The discharging direction of the nozzle may be adjusted according to the installation angle of the substrate.


(Second Film-Forming Apparatus)

Next, a second example of the film-forming apparatus according to the present invention is described below. The following explanation mainly focuses on the differences from the first example. The second example of the film-forming apparatus that performs a mist CVD method includes a substrate heating means having a substrate mounting portion where the substrate is mounted, a film-forming member, and a position adjusting means capable of adjusting the position of the film-forming member to a position other than a position on the substrate mounting portion in the normal direction with respect to the surface of the substrate mounting portion. As described above, if the position of the substrate mounting portion is adjustable with respect to the position of the film-forming member, such as the nozzle 150 or the rectifying top plate, the adverse effect on the substrate when the film-forming member is heated, as in the film-forming method described below, can be suppressed.

The substrate heating means may further be equipped with a substrate non-mounting portion. Further, the position adjusting means for the film-forming member and/or the substrate heating means is preferably capable of adjusting the position of the film-forming member to a position on the substrate non-mounting portion in the normal direction with respect to the surface of the substrate non-mounting portion.

The state in which the position of the film-forming member is in a position on the substrate non-mounting portion in the normal direction with respect to the surface of the substrate non-mounting portion means that the film-forming member is present (located) in the space extending in the normal direction from the substrate non-mounting portion. If the film-forming member is present (located) in the space extending in the normal direction from the substrate mounting portion, it can be said that the position of the film-forming member is located on the substrate mounting portion in the normal direction with respect to the surface of the substrate mounting portion.

The film-forming member may further include a film-forming member heating means for heating the film-forming member. For example, a heating means such as a heater may be provided on the film-forming member such as a nozzle or a rectifying top plate, thereby performing temperature control solely by the film-forming member such as the nozzle or the rectifying top plate.

The film-forming member is not particularly limited as long as it is a member of the film-forming apparatus and is used for the film formation. Examples thereof include a nozzle for supplying mist to the substrate and a top plate for rectifying the supplied mist on the substrate.

(Third Film-Forming Apparatus)

Next, a third example of the film-forming apparatus according to the present invention is described below. The following explanation mainly focuses on the differences from the first example. A third example of a film-forming apparatus that performs the mist CVD method has a substrate heating means having a substrate mounting portion on which a substrate is placed, a nozzle for supplying mist to the substrate, and an exhausting means for exhausting the mist after film formation, wherein the exhausting means has a mechanism for exhausting discharged matters discharged from the nozzle without passing through the substrate mounting portion. As described above, the film-forming chamber 107 is provided with an exhaust gas exhaust port 112 at a position that does not affect the supply of the mist to the substrate 110. The third example of the film-forming apparatus is equipped with, for example, as described above, a position adjusting means for the film-forming member and/or the substrate heating means that is capable of adjusting the relative position of the film-forming member, such as the nozzle 150 and the rectifying top plate, and the substrate mounting portion, so that it provides a mechanism by which the discharged matters discharged from the nozzle can be exhausted by the exhausting means without passing through the substrate mounting portion. This mechanism thus reduces the adverse effects on the substrate when the film-forming member is heated, as in the film-forming method described below.

Film-Forming Method

(First Film-Forming Method)

Next, a first example of the film-forming method according to the present invention is described below with reference to FIGS. 1 to 6. The film-forming method according to the present invention includes a step of heating a substrate; a step of heating a nozzle that supplies mist containing a raw material solution; and a step of forming the crystalline oxide film by supplying the mist onto the heated substrate so that a discharging direction of the heated nozzle is perpendicular to a surface of the substrate, wherein, in the step of heating the nozzle, the nozzle is heated in a state where the substrate is not present in the discharging direction of the nozzle, and, in the step of forming the crystalline oxide film, the film is formed in a state where the substrate is present in the discharging direction of the nozzle.

(Substrate Heating Step)

The aforementioned raw material solution 104a is placed in the mist generation source 104, the substrate 110 is placed inside the film-forming chamber 107, and the heater 108 is activated to heat the substrate to a predetermined temperature.

(Nozzle Heating Step)

Further, the nozzle 150 is also heated. This is because changes in nozzle temperature during the film formation may cause abnormal growth. The nozzle heating method is not particularly limited. As described above with regard to the film-forming apparatus, the temperature of the nozzle may be controlled independently by providing the nozzle heating means 151, such as a heater, in the nozzle. Otherwise, the nozzle may be heated by the substrate heating means 108 until the nozzle temperature stabilizes. When the nozzle is heated by the nozzle heating means provided in the nozzle, the nozzle can be heated efficiently.

Here, the positional relationship between the nozzle 150 and the substrate when the nozzle is heated is such that the substrate is not present in the discharging direction of the nozzle. This is because if the substrate is present in the discharging direction of the nozzle when the nozzle is heated, an unintended film will grow on the substrate, resulting in extremely poor film thickness distribution and crystallinity. Although the cause is unknown, it is assumed that mist or droplets remaining in the nozzle or the tube evaporate due to the heating and adhere to the substrate.

Although it may be possible to place the substrate after the heating of the nozzle is completed, this is not desirable because there is a concern of the effects of temperature changes due to opening and closing of the film-forming chamber. Therefore, in the film-forming method according to the present invention, the problems mentioned above are addressed by, for example, providing a position adjusting means in the substrate heating means or the nozzle.

Examples of the method of heating the nozzle before the film formation are described below with reference to FIGS. 1 to 4. In all cases, the substrate is not present in the discharging direction of the nozzle 150.

As described above, the heating of the nozzle can be performed using a substrate heating means. By performing the heating using the substrate heating means 108 until the temperature of the nozzle stabilizes, the structure of the film-forming apparatus is simplified and also the size of the apparatus itself as well as the footprint can be reduced, which is cost effective. In this case, as shown in FIGS. 1 and 2, the nozzle 150 is preferably heated using the substrate heating means 108 having a substrate mounting portion 111A and a substrate non-mounting portion 111B by placing the substrate on the substrate mounting portion 111A and positioning the substrate non-mounting portion 111B in the discharging direction of the nozzle. This has an advantage in terms of cost; moreover, the nozzle is more efficiently heated.

Further, the heating of the nozzle can also be performed by the nozzle heating means 151 provided in the nozzle 150, as shown in FIGS. 3 and 4. In this case, the heating and the temperature control of the nozzle can be performed more efficiently. Also when the nozzle is heated by the nozzle heating means 151, it is possible to further use the substrate heating means 108 having the substrate mounting portion 111A and the substrate non-mounting portion 111B.

In the examples shown in FIGS. 1 and 3, after the nozzle is heated, the nozzle is moved onto the substrate by the position adjusting means 170 of the nozzle so that the substrate is present in the discharging direction of the nozzle. In FIGS. 2 and 4, after the nozzle is heated, the substrate is moved under the nozzle by the position adjusting means 180 of the substrate heating means so that the substrate is present in the discharging direction of the nozzle.

The nozzle temperature may be 50 to 250°C, for example. The film-forming reaction also depends on the temperature of the environment around the substrate. Therefore, it is desirable to set the temperature of the nozzle, as well as the temperature of the inner wall of the film-forming chamber, to be higher than room temperature.

(Film-Forming Step, etc.)

Once the nozzle temperature has stabilized, the nozzle or the substrate (substrate heating means) is moved so that the substrate is present in the discharging direction of the nozzle to perform the film-forming step.

The film formation by the mist CVD method generally includes the following steps. The film formation by the mist CVD method generally includes a mist generation step of generating mist by atomizing a raw material solution containing gallium into a mist in the mist-forming unit; a carrier gas supply step of supplying a carrier gas for transporting the mist to the mist-forming unit; a transport step of transporting the mist from the mist-forming unit to the film-forming chamber by the carrier gas via the supply tube connecting the mist-forming unit and the film-forming chamber; and a film-forming step of performing a heat treatment of the transported mist to form a film on the substrate. The method is described below.

First, the flow rate control valves 103a and 103b are opened to supply the carrier gas from the carrier gas sources 102a and 102b into the film-forming chamber 107. After the atmosphere in the film-forming chamber 107 is sufficiently replaced with the carrier gas, the flow rate of the carrier gas and the flow rate of the dilution carrier gas are separately adjusted. The flow rate of the carrier gas is not particularly limited. For example, when a film is formed on a substrate of 2 inches, the flow rate of the carrier gas is preferably 0.05 to 50 L/min, and more preferably 5 to 20 L/min.

Next, as the mist generation step, the ultrasonic vibrator 106 is vibrated, and the vibration is propagated to the raw material solution 104a through the water 105a to atomize the raw material solution 104a into a mist, thereby generating a mist.

Next, as the carrier gas supply step, a carrier gas for transporting the mist is supplied to the mist-forming unit 120.

Next, as the transport step, the mist is transported from the mist-forming unit 120 to the film-forming chamber 107 by the carrier gas via the supply tube 109 that connects the mist-forming unit 120 and the film-forming chamber 107.

Next, as the film-forming step, the mist supplied from the supply tube 109 passes through the piping in the film-forming chamber 107, and the mist containing the raw material solution is discharged and supplied from the nozzle 150 to the substrate 110 together with the carrier gas. The mist transported to the film-forming chamber 107 is heated to cause a thermal reaction, thereby forming a film on a part of or the entire surface of the substrate 110.

In this case, as shown in FIG. 5, the mist is supplied onto the heated substrate so that the discharging direction of the heated nozzle is perpendicular to the surface of the substrate to form a crystalline oxide film. Further, the substrate is set so that it is present in the discharging direction of the nozzle. As described above, by adjusting the positional relationship between the nozzle and the substrate upon the nozzle heating and the film formation, it is possible to obtain a crystalline oxide film, which contains gallium oxide as a main component, excellent in crystallinity and ensuring desirable in-plane film thickness distribution even with a small film thickness, and also ensuring excellent semiconductor characteristics when applied to a semiconductor device. In particular, as described above, a crystalline oxide film containing gallium oxide as a main component and having a V-value, which is obtained by the above formula (1), of 0.045 or less for each film thickness at 25 points in its plane may be produced.

The thermal reaction requires heating in order to advance the reaction of gallium or the like contained in the mist. Therefore, the temperature of the substrate surface during the reaction must be 400°C or more. Unlike other CVD methods, the mist CVD method requires the raw materials to reach the substrate surface in a liquid state. This results in a significant decrease in the temperature of the substrate surface. Therefore, the temperature of the substrate surface during the reaction is different from the temperature set in the apparatus. It is preferable to measure the temperature of the substrate surface also during the reaction; however, if this is difficult, the temperature can be measured in an alternative way in which the reaction is simulated by introducing only a carrier gas or water mist containing no solutes.

The thermal reaction may be carried out under any of a vacuum, a non-oxygen atmosphere, a reducing gas atmosphere, an air atmosphere and an oxygen atmosphere, and may be appropriately set according to the film to be formed. Further, the reaction may be carried out under any pressure condition, such as atmospheric pressure, increased or reduced pressure; however, the film formation under atmospheric pressure is preferable because the apparatus structure can be simplified.

(Formation of Buffer Layer)

As mentioned above, a buffer layer may be provided between the substrate and the crystalline oxide film as appropriate. The method for forming a buffer layer is not particularly limited, and the buffer layer can be formed by sputtering, vapor deposition, or other known methods. However, by using the mist CVD method as described above, the buffer layer can be formed in a simple method merely by changing the raw material solution as necessary. Specifically, solutions in which one or more metals selected from aluminum, gallium, chromium, iron, indium, rhodium, vanadium, titanium, iridium are dissolved or dispersed in water in the form of complexes or salts may be suitably used as the raw aqueous solution. Examples of the complex form include an acetylacetonate complex, a carbonyl complex, an ammine complex, a hydride complex, and the like. Examples of the salt form include chloride metal salt, bromide metal salt, iodide metal salt, and the like. Further, a solution in which the above metal is dissolved in hydrobromic acid, hydrochloric acid, or hydroiodic acid, or the like, can also be used as a salt solution. Also in this case, the concentration of the solute is preferably 0.005 to 1 mol/L, and the dissolution temperature is preferably 20°C or more. The other conditions in forming the buffer layer may also be the same as above. After the buffer layer is formed with a predetermined thickness, a crystalline oxide film is formed by the film-forming method according to the present invention.

(Heat Treatment)

Further, the film obtained by the film-forming method according to the present invention may be subjected to a heat treatment at 200 to 600°C. The heat treatment removes unreacted species and the like in the film, thereby yielding a crystalline oxide film of higher quality. The heat treatment may be performed in air, in an oxygen atmosphere, or in an inert gas atmosphere such as with nitrogen or argon. The time for the heat treatment is appropriately determined; for example, the heat treatment time may be 5 to 240 minutes.

(Delamination)

After obtaining the layered structure containing the substrate and the crystalline oxide film, the crystalline oxide film may be delaminated from the substrate. The delaminating means is not particularly limited, and may be any known means. Examples of the methods for the delaminating means include a delaminating means by way of applying mechanical impact, a delaminating means by way of applying heat using thermal stress, a delaminating means by way of applying ultrasonic waves or the like, a delaminating means by way of etching, and the like. By the delamination, the crystalline oxide film can be obtained as a freestanding film.

(Second Film-Forming Method)

Next, a second example of the film-forming method according to the present invention is described below. The film-forming method of the second example is a film-forming method for forming a crystalline oxide film, which contains gallium oxide as a main component, on a substrate by a mist CVD method, including: a step of heating a substrate; a step of heating a film-forming member; and a step of forming the crystalline oxide film by supplying mist in a state where the heated film-forming member is present on the substrate in a normal direction with respect to a surface of the substrate, wherein, in the step of heating the film-forming member, the film-forming member is heated in a state where the film-forming member is not present on the substrate in the normal direction with respect to the surface of the substrate. The following explanation mainly focuses on the differences from the film-forming method of the first example.

(Step of Heating Film-Forming Member)

In the step of heating the film-forming member, the film-forming member, such as the nozzles 150 or a rectifying top plate, is heated. This is because changes in the temperature of the film-forming member, such as the nozzle or the rectifying top plate, during the film formation may cause abnormal growth. The method for heating the film-forming member, such as the nozzle or the rectifying top plate, is not particularly limited. As explained with regard to the above film-forming apparatus, the temperature of the film-forming member, such as the nozzle or the rectifying top plate, may be controlled independently by providing a heater or other heating means on the film-forming member, such as the nozzle or the rectifying top plate, or heating the film-forming member, such as the nozzle or the rectifying top plate, by the substrate heating means 108 until the temperature of the film-forming member stabilizes. In the case of heating the film-forming member, such as the nozzle or the rectifying top plate, by a heating means provided in the film-forming member, such as the nozzle or the rectifying top plate, the film-forming member, such as the nozzle or the rectifying top plate, can be heated efficiently.

Here, the positional relationship between the film-forming member, such as the nozzle 150 or the rectifying top plate, and the substrate in the heating of the film-forming member, such as the nozzle or the rectifying top plate, is such that the film-forming member is not present on the substrate in the normal direction with respect to the surface of the substrate. In other words, the film-forming member is not present in the space where the substrate extends in the normal direction. This method allows gases or the like discharged from the nozzle to be exhausted without passing through the substrate when the nozzle is heated to a predetermined temperature.

If the film-forming member is positioned on the substrate in the normal direction with respect to the surface of the substrate during the heating of the film-forming member, such as the nozzle or the rectifying top plate, unintended films grow on the substrate, which results in extremely poor film thickness distribution and crystallinity. Although the cause is unknown, it is assumed that mist or droplets remaining in the film-forming member, such as the nozzle or the rectifying top plate, or the tube evaporate due to the heating and adhere to the substrate.

Although it may be possible to place the substrate after the heating of the film-forming member, such as the nozzle or the rectifying top plate, is completed, this is not desirable because there is a concern of the effects of temperature changes due to opening and closing of the film-forming chamber. Therefore, in the second example of the film-forming method according to the present invention, the problems mentioned above are addressed by, for example, providing a position adjusting means in the substrate heating means or the film-forming member, such as the nozzle or the rectifying top plate.

The step of heating the substrate is preferably performed such that a substrate heating means having a substrate mounting portion and a substrate non-mounting portion is used, and the substrate is heated by being placed on the substrate mounting portion, and the step of heating the film-forming member is preferably performed such that the film-forming member is positioned on the substrate non-mounting portion in a normal direction with respect to a surface of the substrate non-mounting portion, and the film-forming member is heated by the substrate heating means.

Further, the step of heating the film-forming member is preferably performed such that the film-forming member is heated by a film-forming member heating means provided in the film-forming member.

The film-forming member is a nozzle for supplying mist onto the substrate, and the step of heating the film-forming member is preferably performed such that the nozzle is heated in a state where a discharging port of the nozzle is not present on the substrate in the normal direction with respect to the surface of the substrate.

(Third Film-Forming Method)

Next, a third example of the film-forming method according to the present invention is described below. The third example includes a step of heating a substrate; a step of heating a nozzle that supplies mist containing a raw material solution to a predetermined temperature; and a step of leading the mist to the substrate to form a crystalline oxide film, and exhausting the mist after film formation. This is a film-forming method for forming a crystalline oxide film, which contains gallium oxide as a main component, on a substrate by a mist CVD method in which, in the step of heating the nozzle to a predetermined temperature, discharged matters discharged from the nozzle are exhausted without passing through the substrate. Such a film-forming method makes it possible to obtain a crystalline oxide film, which contains gallium oxide as a main component, excellent in crystallinity and ensuring desirable in-plane film thickness distribution even with a small film thickness, and also ensuring excellent semiconductor characteristics when applied to a semiconductor device. Such a film-forming method can be performed using an apparatus such as that shown in the third example of the film-forming apparatus described above.

EXAMPLES

Hereinafter, the present invention is specifically described with reference to examples; however, the present invention is not limited to these examples.

Example 1

The film-forming apparatus 101 used in the present example is described below with reference to FIG. 5. The film-forming apparatus 101 includes the carrier gas source 102a that supplies a carrier gas; the flow rate control valve 103a for adjusting the flow rate of the carrier gas supplied from the carrier gas source 102a; the dilution carrier gas source 102b that supplies a dilution carrier gas; the flow rate control valve 103b for adjusting the flow rate of the dilution carrier gas supplied from the dilution carrier gas source 102b; the mist generation source 104 containing the raw material solution 104a; the container 105 containing water 105a; the ultrasonic vibrator 106 attached to the bottom of the container 105; the film-forming chamber 107 equipped with the substrate heating means 108; the quartz supply tube 109 connecting the mist generation source 104 to the film-forming chamber 107; and the nozzle 150. Further, as shown in FIG. 2, the substrate heating means 108 has a transport mechanism that sets a state in which the substrate is not present in the vertical direction, which is the discharging direction of the nozzle, before the film formation.

A 4-inch (100 mm) c-face sapphire substrate was prepared as the substrate 110, and the substrate was placed in the film-forming chamber 107. Before the film formation was started, the substrate heating means 108 was moved as shown in FIG. 2 so that the nozzle is not present in the vertical direction with respect to the substrate. Then, the substrate heating means 108 was set at and heated to 450°C, and then the substrate heating means 108 was allowed to stand for 30 minutes to stabilize the temperature in the film-forming chamber, including the nozzle. The temperature at the top of the nozzle 150 in this state was measured using a thermocouple, and was found as 146°C. After confirming that the nozzle temperature had stabilized, the substrate heating means 108 was moved to the position in the discharging direction under the nozzle (from the position in FIG. 2 to the position in FIG. 5), together with the substrate.

In the raw material solution 104a, the solvent was ultrapure water and the solute was gallium bromide. The concentration of gallium was 0.1 mol/L. The resulting raw material solution 104a was stored in the mist generation source 104. Then, the flow rate control valves 103a and 103b were opened to supply the carrier gas from the carrier gas sources 102a and 102b into the film-forming chamber 107. After the atmosphere in the film-forming chamber 107 was sufficiently replaced with the carrier gas, the flow rate of the carrier gas and the flow rate of the dilution carrier gas were separately adjusted to 2L/min and 6L/min, respectively. Nitrogen was used as the carrier gas.

Next, the ultrasonic vibrator 106 was vibrated at 2.4 MHz, and the vibration was propagated to the raw material solution 104a through the water 105a, thereby atomizing the raw material solution 104a into a mist to generate a mist. The mist was introduced into the film-forming chamber 107 via the supply tube 109 by the carrier gas, and the mist was thermally reacted on the substrate 110 to form a thin film of gallium oxide on the substrate 110. The film formation time was 30 minutes.

(Evaluation)

Regarding the thin film formed on the substrate 110, the formation of $\alpha$-$Ga_2O_3$ was confirmed by X-ray diffraction. The rocking curve of the (006) plane of the $\alpha$-$Ga_2O_3$ was measured, and the half-width thereof was found as 9.2 seconds, indicating extremely good crystallinity. The film thickness was measured at 25 points in the plane using a F50 reflective spectroscopic film thickness meter (Philmetrics). The average film thickness was 824 nm, and the V-value obtained by the above formula (1) was 0.040. Also in terms of the appearance, the color was uniform throughout the plane, indicating excellent film thickness distribution. Further, when SBDs, which are semiconductor devices, were manufactured using this layered structure, a product lot of 66 SBDs had a breakdown voltage yield of 82%.

Comparative Example

In Example 1, the substrate and the nozzle were heated to increase the temperature in a state where the nozzle was present vertically above the substrate before the film formation. Otherwise, the film formation and the evaluation were performed in the same manner as in Example 1. As a result, the average film thickness was 932 nm and the V-value obtained by the formula (1) was 0.046. In addition, with regard to the reflection light from the substrate, various color distributions were visible in the plane to the naked eye, and the appearance was also not satisfactory. Further, when SBDs, which are semiconductor devices, were manufactured using this layered structure, a product lot of 66 SBDs had a breakdown voltage yield of 30%.

Examples 2 to 7

Experiments and evaluations were conducted in the same manner as in Example 1, except for the conditions shown in the table below.

Table 1

| Examples | Substrate Size | Heating Member and Its State | Heating Time (min) | Temperature (°c) for Heating Member | Average Film Thickness (run) | V-value | Breakdown Voltage Yield (%) |
|---|---|---|---|---|---|---|---|
| Example 1 | 4 inches | Not present in vertical direction with respect to nozzle/substrate | 30 | 146 | 824 | 0.040 | 82 |
| Comparative Example | 4 inches | In vertical direction with respect to nozzle/ substrate | 30 | 156 | 932 | 0.046 | 30 |
| Example 2 | 4 inches | Not present in vertical direction with respect to rectifying top plate and nozzle/ substrate | 30 | 145 | 833 | 0.040 | 86 |
| Example 3 | 4 inches | Heating with thermal heater provided in nozzle | 30 | 180 | 842 | 0.040 | 89 |
| Example 4 | 6 inches | Not present in vertical direction with respect to nozzle/substrate | 30 | 152 | 815 | 0.041 | 80 |
| Example 5 | 6 inches | Not present in vertical direction with respect to rectifying top plate and nozzle/ substrate | 30 | 155 | 831 | 0.040 | 85 |
| Example 6 | 8 inches | Not present in vertical direction with respect to nozzle/substrate | 30 | 172 | 841 | 0.041 | 79 |
| Example 7 | 8 inches | Not present in vertical direction with respect to rectifying top plate and nozzle/ substrate | 30 | 169 | 837 | 0.041 | 83 |

These results revealed that the film thickness distribution can be greatly improved by the simple method of heating the nozzle in a state where the substrate is not present in the discharging direction of the nozzle before the film formation. The crystalline gallium oxide film obtained by the film-forming method according to the present invention is useful for semiconductor devices and the like, because of its large area, excellent film thickness distribution, and excellent crystallinity.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

**Claims**

1.  A film-forming method for forming a crystalline oxide film, which contains gallium oxide as a main component, on a substrate by a mist CVD method, comprising:

    a step of heating a substrate;
    a step of heating a nozzle that supplies mist containing a raw material solution; and
    a step of forming the crystalline oxide film by supplying the mist onto the heated substrate so that a discharging direction of the heated nozzle is perpendicular to a surface of the substrate,
    wherein
    in the step of heating the nozzle, the nozzle is heated in a state where the substrate is not present in the discharging direction of the nozzle, and
    in the step of forming the crystalline oxide film, the film is formed in a state where the substrate is present in the discharging direction of the nozzle.

2.  The film-forming method according to claim 1, wherein

    the substrate is heated by using a substrate heating means having a substrate mounting portion and a substrate non-mounting portion by placing the substrate on the substrate mounting portion, and
    in the step of heating the nozzle, the nozzle is heated by the substrate heating means while positioning the substrate non-mounting portion in the discharging direction of the nozzle.

3.  The film-forming method according to claim 1 or 2, wherein the nozzle is heated by a nozzle heating means provided in the nozzle.

4.  A film-forming method for forming a crystalline oxide film, which contains gallium oxide as a main component, on a substrate by a mist CVD method, comprising:

    a step of heating a substrate;
    a step of heating a film-forming member; and
    a step of forming the crystalline oxide film by supplying mist in a state where the heated film-forming member is present on the substrate in a normal direction with respect to a surface of the substrate,
    wherein, in the step of heating the film-forming member, the film-forming member is heated in a state where the film-forming member is not present on the substrate in the normal direction with respect to the surface of the substrate.

5.  The film-forming method according to claim 4, wherein

    in the step of heating the substrate, a substrate heating means having a substrate mounting portion and a substrate non-mounting portion is used, and the substrate is heated by being placed on the substrate mounting portion, and
    in the step of heating the film-forming member, the film-forming member is positioned on the substrate non-mounting portion in a normal direction with respect to a surface of the substrate non-mounting portion, and the film-forming member is heated by the substrate heating means.

6.  The film-forming method according to claim 4 or 5, wherein, in the step of heating the film-forming member, the film-forming member is heated by a film-forming member heating means provided in the film-forming member.

7.  The film-forming method according to any one of claims 4 to 6, wherein

    the film-forming member is a nozzle for supplying the mist onto the substrate, and
    in the step of heating the film-forming member, the nozzle is heated in a state where a discharging port of the nozzle is not present on the substrate in the normal direction with respect to the surface of the substrate.

8.  The film-forming method according to any one of claims 1 to 7, wherein a substrate having a film-forming surface with an area of $100\ mm^2$ or more or a substrate having a diameter of 2 inches (50 mm) or more is used as the substrate.

9.  The film-forming method according to any one of claims 1 to 8, wherein a substrate having a diameter of 4 inches (100 mm) to 8 inches (200 mm) is used as the substrate.

10. A film-forming apparatus that performs a mist CVD method, comprising:

a substrate heating means having a substrate mounting portion on which a substrate is mounted;
a nozzle that supplies mist containing a raw material solution, a discharge direction of which is perpendicular to a surface of the substrate; and
a position adjusting means for the nozzle and/or the substrate heating means, the position adjusting means being capable of adjusting a position of the substrate mounting portion to a position in the discharging direction of the nozzle and to a position other than the discharging direction of the nozzle.

11. The film-forming apparatus according to claim 10, wherein

the substrate heating means further comprises a substrate non-mounting portion, and
the position adjusting means for the nozzle and/or the substrate heating means is capable of adjusting a position of the substrate non-mounting portion to a position of the discharging direction of the nozzle.

12. The film-forming apparatus according to claim 10 or 11, wherein the nozzle comprises a nozzle heating means for heating the nozzle.

13. A film-forming apparatus that performs a mist CVD method, comprising:

a substrate heating means having a substrate mounting portion on which a substrate is mounted;
a film-forming member; and
a position adjusting means capable of adjusting a position of the film-forming member to a position other than a position on the substrate mounting portion in a normal direction with respect to a surface of the substrate mounting portion.

14. The film-forming apparatus according to claim 13, wherein

the substrate heating means further comprises a substrate non-mounting portion, and
the position adjusting means for the film-forming member and/or the substrate heating means is capable of adjusting the position of the film-forming member to a position on the substrate non-mounting portion in a normal direction with respect to a surface of the substrate non-mounting portion.

15. The film-forming apparatus according to claim 13 or 14, wherein the film-forming member comprises a film-forming member heating means for heating the film-forming member.

16. The film-forming apparatus according to any one of claims 13 to 15, wherein the film-forming member is a nozzle for supplying mist onto the substrate or a top plate for rectifying the supplied mist on the substrate.

17. A crystalline oxide film containing gallium oxide as a main component, the crystalline oxide film having a V-value of 0.045 or less for each film thickness at 25 points in its plane, the V-value being obtained by the following formula (1),
[Math. 1]

$$V = \frac{\sum_{i=1}^{25} x_i^{\,2}}{\left(\sum_{i=1}^{25} x_i\right)^2} \tag{1}$$

wherein $x_i$ is an i-th (i=1 to 25) measurement value.

18. The crystalline oxide film according to claim 17, wherein the V-value is 0.041 or less.

19. A layered structure comprising a substrate having a diameter of 4 inches (100 mm) to 8 inches (200 mm) and the crystalline oxide film according to claim 17 or 18 provided on the substrate.

20. A product lot of semiconductor devices, comprising two or more of only semiconductor device produced from the layered structure according to claim 19, and having a breakdown voltage yield of 75% or more.

21. A film-forming method for forming a crystalline oxide film, which contains gallium oxide as a main component, on a substrate by a mist CVD method, comprising:

a step of heating a substrate;
a step of heating a nozzle that supplies mist containing a raw material solution to a predetermined temperature; and
a step of leading the mist to the substrate to form a crystalline oxide film, and exhausting the mist after film formation,
wherein, in the step of heating the nozzle to a predetermined temperature, discharged matters discharged from the nozzle are exhausted without passing through the substrate.

22. A film-forming apparatus that performs a mist CVD method, comprising:

a substrate heating means having a substrate mounting portion on which a substrate is mounted;
a nozzle for supplying mist onto the substrate; and
an exhausting means for exhausting the mist after film formation,
wherein the exhausting means has a mechanism that exhausts discharged matters discharged from the nozzle without passing through the substrate mounting portion.

[FIG. 1]

[FIG. 2]

EP 4 407 660 A1

[FIG. 3]

[FIG. 4]

22

[FIG. 5]

101

130 103a 103b 109 107 112

102b 102a 104 104a 150 110 108

105 106 105a 120

[FIG. 6]

120

104 104a 105 105a

106 116

[FIG. 7]

## INTERNATIONAL SEARCH REPORT

| International application No. |
| --- |
| **PCT/JP2022/032486** |

**A. CLASSIFICATION OF SUBJECT MATTER**

*H01L 21/365*(2006.01)i; *H01L 21/368*(2006.01)i; *C30B 29/16*(2006.01)i; *C23C 16/40*(2006.01)i; *C23C 16/455*(2006.01)i
FI: H01L21/365; H01L21/368 Z; C30B29/16; C23C16/40; C23C16/455

According to International Patent Classification (IPC) or to both national classification and IPC

**B. FIELDS SEARCHED**

Minimum documentation searched (classification system followed by classification symbols)

H01L21/365; H01L21/368; C30B29/16; C23C16/40; C23C16/455

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2014/170972 A1 (TOSHIBA MITSUBISHI-ELECTRIC INDUSTRIAL SYSTEMS CORPORATION) 23 October 2014 (2014-10-23) paragraphs [0011]-[0017], fig. 1-2 | 10, 13, 16 |
| A | entire text, all drawings | 1-9, 11-12, 14-15, 21-22 |
| Y | JP 2016-146442 A (FLOSFIA INC) 12 August 2016 (2016-08-12) paragraphs [0002], [0015], [0020]-[0023], [0032]-[0037], fig. 1, 4, 8 | 17-20 |
| A | entire text, all drawings | 1-9, 11-12, 14-15, 21-22 |
| Y | JP 2020-2396 A (SHINETSU CHEMICAL CO) 09 January 2020 (2020-01-09) paragraphs [0002], [0031], [0037]-[0048], [0051]-[0063], fig. 1, 3-6 | 17-20 |
| A | entire text, all drawings | 1-9, 11-12, 14-15, 21-22 |
| A | JP 2020-2426 A (SHINETSU CHEMICAL CO) 09 January 2020 (2020-01-09) paragraphs [0023], [0028], [0030]-[0033], [0038]-[0051], fig. 1, 3-4 | 1-9, 11-12, 14-15, 21-22 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **17 October 2022** | **25 October 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/032486**

| Patent document cited in search report | | | Publication date (day/month/year) | Patent family member(s) | Publication date (day/month/year) |
|---|---|---|---|---|---|
| WO | 2014/170972 | A1 | 23 October 2014 | US 2016/0047037 A1 paragraphs [0015]-[0021], fig. 1-2 CN 105121699 A KR 10-2015-0130393 A | |
| JP | 2016-146442 | A | 12 August 2016 | US 2016/0222511 A1 paragraphs [0002], [0034], [0039]-[0043], [0053]-[0058], fig. 1, 4, 8 KR 10-2016-0093510 A CN 105986246 A | |
| JP | 2020-2396 | A | 09 January 2020 | (Family: none) | |
| JP | 2020-2426 | A | 09 January 2020 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5397794 B
- JP 5343224 B
- JP 5397795 B
- JP 2014072533 A
- JP 2016100592 A

- JP 2016098166 A
- JP 2016100593 A
- JP 2016155714 A
- JP 2019034883 A
- WO 2021065940 A1